# EUROPEAN PATENT APPLICATION

(11) **EP 2 273 564 A2**
(43) Date of publication of application: **12.01.2011**
(21) Application number: 10160303.3
(22) Date of filing: 19.04.2010
(51) Int. Cl.: H01L 31/075, H01L 31/18, H01L 27/142, H01L 31/028, H01L 31/0352, H01L 31/0368, H01L 31/0376, H01L 31/20

(54) **Photovoltaic device and manufacturing method thereof**

(30) Priority: 03.07.2009 KR 20090060742
(71) Applicant: KISCO, Changwon-si Gyeongsangnam-do 641-370 (KR)
(72) Inventor: MYONG, Seung-Yeop, 156-831, Seoul (KR)
(74) Representative: Ferreccio, Rinaldo

(57) **Abstract**

Provided is a photovoltaic device. The photovoltaic device includes:
a substrate (100);
a first electrode (210) disposed on the substrate;
at least one photoelectric transformation layer (230) disposed on the first electrode, the photoelectric transformation layer including a light absorbing layer (233); and
a second electrode (250) disposed on the photoelectric transformation layer;
wherein the light absorbing layer (233) includes a first sub-layer (233a) and a second sub-layer (233b), each of which includes a hydrogenated amorphous silicon based material respectively; and
wherein the first sub-layer and the second sub-layer include a non-silicon based element, and the second sub-layer includes a crystalline silicon grain surrounded by the hydrogenated amorphous silicon based element.

## Description

This application claims the benefit of Korean Patent Application No. 10-2009-0060742 filed on July 3, 2009, which is hereby incorporated by reference.

### BACKGROUND

### Field

This application relates to a photovoltaic device and a manufacturing method thereof.

### Description of the Related Art

Recently, as existing energy sources such as oil and charcoal and so on are expected to be exhausted, attention is now paid to alternative energy sources which can be used in place of the existing energy sources. Among the alternative energy sources, sunlight energy is abundant and has no environmental pollution. For this reason, more and more attention is paid to the sunlight energy.

A photovoltaic device, that is to say, a solar cell converts directly sunlight energy into electrical energy. The photovoltaic device uses mainly photovoltaic effect of semiconductor junction- In other words, when light is incident and absorbed to a semiconductor pin junction formed through a doping process by means of p-type and n-type impurities respectively, light energy generates electrons and holes at the inside of the semiconductor. Then, the electrons and the holes are separated by an internal field so that a photo-electro motive force is generated at both ends of the pin junction. Here, if electrodes are formed at the both ends of junction and connected with wires, an electric current flows externally through the electrodes and the wires.

In order that the existing energy sources such as oil is substituted with the sunlight energy source, it is required that a degradation rate of the photovoltaic device should be low and a stability efficiency of the photovoltaic device should be high, which are produced by the elapse of time.

### SUMMARY

One aspect of this invention includes a photovoltaic device The photovoltaic device includes:
a substrate;
a first electrode disposed on the substrate;
at least one photoelectric transformation layer disposed on the first electrode, the photoelectric transformation layer including a light absorbing layer; and
a second electrode disposed on the photoelectric transformation layer;
wherein the light absorbing layer includes a first sub-layer and a second sub-layer, each of which includes a hydrogenated amorphous silicon based material respectively; and
wherein the first sub-layer and the second sub-layer include a non-silicon based element, and the second sub-layer includes a crystalline silicon grain surrounded by the hydrogenated amorphous silicon based material.

Another aspect of this invention includes a photovoltaic device. The photovoltaic device includes::
a substrate;
a first electrode disposed on the substrate;
a first photoelectric transformation layer disposed on the first electrode, the first photoelectric transformation layer including a light absorbing layer;
a second photoelectric transformation layer including the light absorbing layer and being disposed on the first photoelectric transformation layer; and
a second electrode disposed in on the second photoelectric transformation layer;
wherein the light absorbing layer included in the second photoelectric transformation layer includes a first sub-layer and a second sub-layer, each of which includes hydrogenated micro-crystalline silicon germanium and hydrogenated micro-crystalline silicon (µc-Si:H) respectively.

One aspect of this invention includes a method of manufacturing a photovoltaic device. The method includes:
forming a first electrode on a substrate; forming at least one photoelectric transformation layer on the first electrode in a chamber, the photoelectric transformation layer including a light absorbing layer; forming a second electrode on the photoelectric transformation layer;
wherein flow rates of hydrogen and silage which are supplied to the chamber are constant while the light absorbing layer is formed;
and wherein, while the light absorbing layer is formed, a flow rate of source gas, which is supplied to the chamber and includes a non-silicon based element, varies alternately within a range between a first flow rate value and a second flow rate value in accordance with a deposition time ; and
wherein at least one of the first flow rate value and the second flow rate value varies in accordance with the elapse of the deposition time while the light absorbing layer is formed.

Another aspect of this invention includes a method of manufacturing a photovoltaic device. The method includes:
forming a first electrode on a substrate; forming at least one photoelectric transformation layer on the first electrode in a chamber, the photoelectric transformation layer including a light absorbing layer; forming a second electrode on the photoelectric transformation layer;
wherein flow rates of hydrogen and silane which are supplied to the chamber are constant while the light absorbing layer is formed; and
wherein, while the light absorbing layer is formed, a flow rate of source gas, which is supplied to the chamber and includes a non-silicon based element, varies alternately within a range between a first flow rate value and a second flow rate value in accordance with a deposition time ;
and wherein, during one cycle derived from a sum of a duration time of the first flow rate value and a duration time of the second flow rate value, at least one of the duration times of the first flow rate value and the second flow rate value varies in accordance with the elapse of the deposition time.

### BRIEF DESCRIPTION OF THE DRAWINGS

The embodiment will be described in detail with reference to the following drawings.
Fig. 1 shows a photovoltaic device according to a first embodiment of the present invention.
Fig. 2 shows another photovoltaic device according to a second embodiment of the present invention.
Figs, 3A to 3H show a manufacturing method of a photovoltaic device according to an embodiment of the present invention.
Fig. 4 shows a plasma-enhanced chemical vapor deposition apparatus for forming a light absorbing layer according to an embodiment of the present invention.
Figs. 5A to 5B show a variation of flow rate of source gas for forming a light absorbing layer according to an embodiment of the present invention
Figs. 6A to 6B show another variation of flow rate of source gas for forming a light absorbing layer according to an embodiment of the present invention.
Figs. 7A to 7B show further another variation of flow rate of source gas for forming a light absorbing layer according to an embodiment of the present invention.
Fig. 8 shows a light absorbing layer including a plurality of sub-layers included in an embodiment of the present invention.
Fig. 9 shows a light absorbing layer including a proto-crystalline silicon layer.

### DETAILED DESCRIPTION OF EMBODIMENTS

Embodiments will be described in a more detailed manner with reference to the drawings.

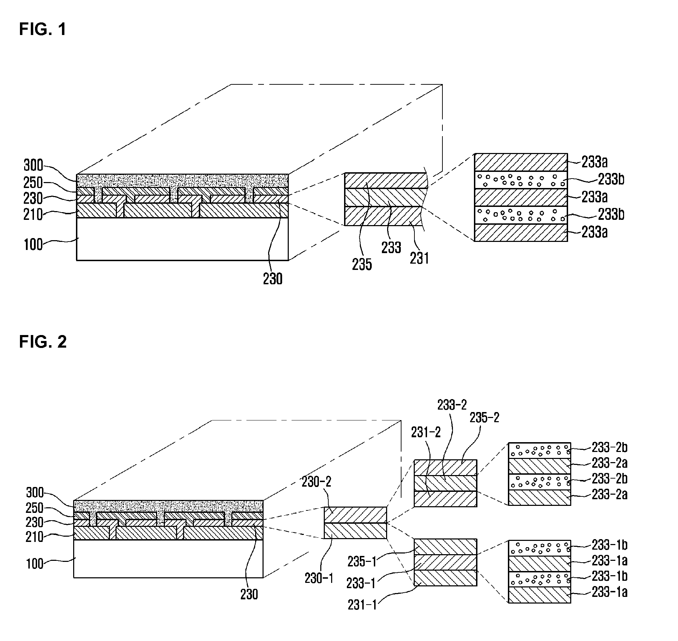

Fig. 1 shows a photovoltaic device according to a first embodiment of the present invention.

As shown, a photovoltaic device includes a substrate 100, a first electrode 210, a second electrode 250, a photoelectric transformation layer 230 and a protecting layer 300.

In detail, the first electrodes 210 are disposed on the substrate 100. The first electrodes 210 are spaced from each other at a regular interval in such a manner that adjacent first electrodes are not electrically short-circuited. The photoelectric transformation layer 230 is disposed on the first electrode 210 in such a manner as to cover the area spaced between the first electrodes at a regular interval. The second electrodes 250 are disposed on the photoelectric transformation layer 230 and spaced from each other at a regular interval in such a manner that adjacent second electrodes are not electrically short-circuited. In this case, the second electrode 250 penetrates the photoelectric transformation layer and is electrically connected to the first electrode 210 such that the second electrode 250 is connected in series to the first electrode 210. The adjacent photoelectric transformation layers 230 are spaced at the same interval as the interval between the second electrodes. The protecting layer 300 is disposed on the second electrode in such a manner as to cover the area spaced between the second electrodes and the area spaced between the photoelectric transformation layers.

The photoelectric transformation layer 230 includes a p-type semiconductor layer 231, a light absorbing layer 233 and an n-type semiconductor layer 235. The light absorbing layer 233 includes a first sub-layer 233A and a second sub-layer 233B stacked on the first sub-layer 233A. The first sub-layer 233A and the second sub-layer 233B include a hydrogenated amorphous silicon based material respectively. The first sub-layer 233A and the second sub-layer 233B also include a non-silicon based element. The second sub-layer 233B includes a crystalline silicon grain surrounded by the hydrogenated amorphous silicon based material.

Fig, 2 shows another photovoltaic device according to a second embodiment of the present invention.

Since a photovoltaic device of Fig. 2 is almost similar to that of Fig.1, descriptions of the same structure will be omitted. In Fig. 2, the photoelectric transformation layer 230 includes a first photoelectric transformation layer 230-1 and a second photoelectric transformation layer 230-2 disposed on the first photoelectric transformation layer. The first photoelectric transformation layer and the second photoelectric transformation layer include p-type semiconductor layers 231-1 and 231-2, light absorbing layers 233-1 and 233-2 and n-type semiconductor layers 235-1 and 235-2.

The light absorbing layers 233-1 and 233-2 include first sub-layers 233-1A and 233-2A and second sub-layers 233-1B and 233-2B stacked on the first sub-layers. Here, the light absorbing layer 233-1 included in the first photoelectric transformation layer 230-1 includes the first sub-layer 233-1A and the second sub-layer 233-1B, The first sub-layer 233-1A includes the hydrogenated amorphous silicon based material and the second sub-layer 233-1B includes the hydrogenated amorphous silicon based material and a crystalline silicon grain surrounded by the hydrogenated amorphous silicon based material. The light absorbing layer 233-2 included in the second photoelectric transformation layer 230-2 includes the first sub-layer 233-2A and the second sub-layer 233-2B. The first sub-layer 233-2A includes hydrogenated micro-crystalline silicon germanium and the second sub-layer 233-2B includes hydrogenated micro-crystalline silicon.

While only two photoelectric transformation layers are provided in the present embodiment, three or more photoelectric transformation layers can be also provided. Regarding a second photoelectric transformation layer or a third photoelectric transformation layer among three photoelectric transformation layers, which is far from a side of incident light, the second photoelectric transformation layer or the third photoelectric transformation layer can include a light absorbing layer including a first sub-layer and a second sub-layer. The first sub-layer includes hydrogenated micro-crystalline silicon germanium and the second sub-layer includes hydrogenated micro-crystalline silicon.

With respect to such photovoltaic devices according to the first and the second embodiments, a manufacturing method of the photovoltaic device will be described below in more detail.

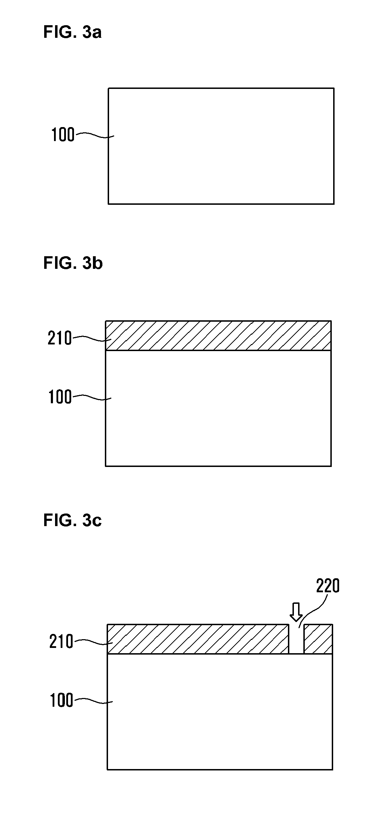

Figs 3A to 3H show a manufacturing method of a photovoltaic device according to an embodiment of the present invention.

As shown in Fig, 3A, a substrate 100 is provided first. An insulating transparent substrate 100 can be used as the substrate 100.

As shown in Fig, 3B, a first electrode 210 is formed on the substrate 100. In the embodiment of the present invention, the first electrode 210 can be made by chemical vapor deposition (CVD) or be made of transparent conductive oxide (TCO) such as SnO2 or ZnO.

As shown in Fig. 3C, a laser beam is irradiated onto the first electrode 210 or the substrate 100 so that the first electrode 210 is partially removed. As a result, a first separation groove 220 is formed. That is, since the separation groove 210 penetrates the first electrode 210, preventing adjacent first electrodes from being short-circuited.

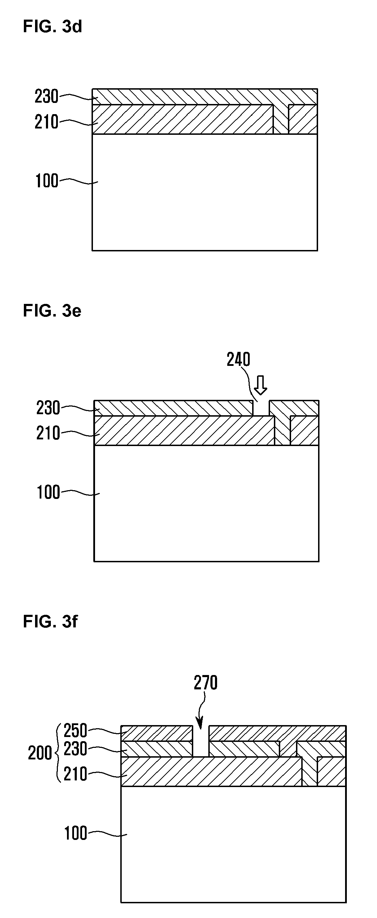

As shown in Fig. 3D, at least one photoelectric transformation layer 230 including a light absorbing layer is stacked by CVD in such a manner as to cover the first electrode 210 and the first separation groove 220. In this case, each photoelectric transformation layer 230 includes a p-type semiconductor layer, a light absorbing layer and an n-type semiconductor layer. In order to form the p-type semiconductor layer, source gas including silicon, for example, SiH4 and source gas including group 3 elements, for example, B2H6 are mixed in a reaction chamber, and then the p-type semiconductor layer is formed by CVD. Then, the source gas including silicon is flown to the reaction chamber so that the light absorbing layer is formed on the p-type semiconductor layer by CVD. A method of manufacturing the light absorbing layer will be described later in detail. Finally, reaction gas including group 5 element, for example, PH3 and source gas including silicon are mixed, and then the n-type semiconductor layer is stacked on an intrinsic semiconductor by CVD. Accordingly, the p-type semiconductor layer, the light absorbing layer and the n-type semiconductor layer are stacked on the first electrode 210 in order specified.

The light absorbing layer according to the embodiment of the present invention can be included in a single junction photovoltaic device including one photoelectric transformation layer 230 or in a multiple junction photovoltaic device including a plurality of photoelectric transformation layers.

As shown in Fig. 3E, a laser beam is irradiated from the air onto the substrate 100 or the photoelectric transformation layer 230 so that the photoelectric transformation layer 230 is partially removed. A second separation groove 240 is hereby formed in the photoelectric transformation layer 230

As shown in Fig. 3F, the second electrode 250 is formed by CVD or sputtering process to cover the photoelectric transformation layer 230 and the second separation groove 240. A metal layer made of Al or Ag can be used as the second electrode 250.

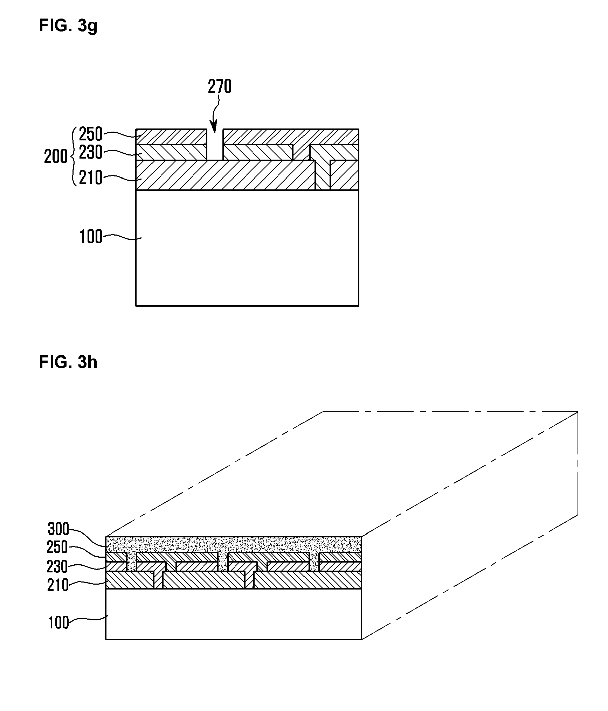

As shown in Fig. 3G, a laser beam is irradiated from the air onto the substrate 100 so that the photoelectric transformation layer 230 and the second electrode 250 are partially removed. As a result, a third separation groove 270 is formed in the photo voltaic layer 230 and the second electrode 250.

As shown in Fig. 3H, through lamination process, a protecting layer 300 covers partially or entirely a photovoltaic cell 200 including the photoelectric transformation layer 230, the first electrode 210 and the second electrode 250 so as to protect the photovoltaic cell 200. The protecting layer 300 can include ethylene Vinyl Acetate (EVA).

Through such a process, provided is the photoelectric transformation layer 200 having the protecting layer 300 formed thereon. A backsheet (not shown) can be made on the protecting layer.

In the next place, a manufacturing method of the light absorbing layer will be described in detail with reference to figures.

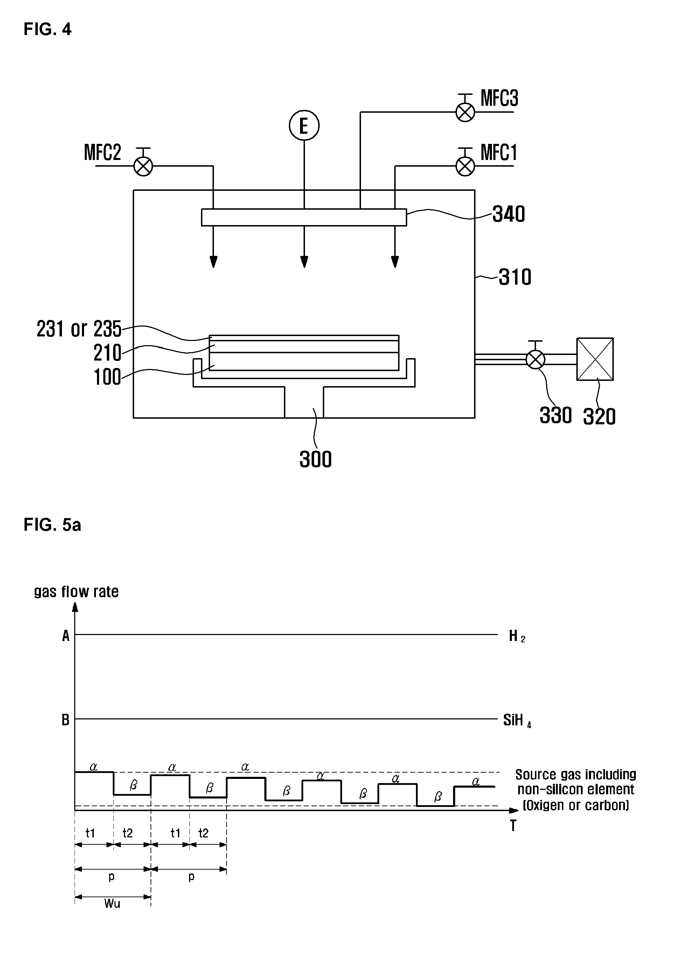

Fig. 4 shows a plasma-enhanced chemical vapor deposition apparatus for forming a light absorbing layer according to an embodiment of the present invention. As shown in Fig. 4, the first electrode 210, the p-type semiconductor layer 231 or the n-type semiconductor layer 235 are formed on the substrate 100. The substrate 100 is disposed on a plate 300 functioning as an electrode. A vacuum pump 320 operates in order to remove impurities in a chamber 310 before the light absorbing layer forming process. As a result, the impurities in the chamber 310 are removed through an angle valve 330 so that the inside of the chamber 310 is actually in a vacuum state.

When the inside of the chamber 310 is actually in a vacuum state, source gas such as hydrogen (H2) and silane (SiH4) and source gas including non-silicon based element are flown to the inside of the chamber 310 through mass flow controllers Mac1, MFC2 and MFC3 and an electrode 340 having a nozzle formed therein.

In other words, the hydrogen can be flown to the chamber through a first mass flow controller MFC 1. The silane can be flown to the chamber through a second mass flow controller MFC2. The non-silicon based element such as carbon, oxygen or germanium can be flown to the chamber through a third mass flow controller MFC3.

Here, the angle valve 330 is controlled to maintain the pressure of the chamber 310 constant. When the pressure of the chamber 310 is maintained constant, silicon powder caused by a vortex created in the chamber 310 can be prevented from being generated and deposition condition can be maintained constant. The hydrogen is flown to the chamber in order to dilute the silane and reduces Staebler-Wronski effect.

When the source gases are flown to the chamber and a voltage from an electric power source E is supplied to the electrode, an electric potential difference is generated between the electrode 340 and the plate 300. As a result, the source gas is in a plasma state, and the light absorbing layer is deposited on the p-type semiconductor layer 231 or the n-type semiconductor layer 235.

Figs. 5A to 5B show a variation of flow rate of source gas for forming a light absorbing layer according to an embodiment of' the present invention.

As shown in Fig.5A, a flow rate A of hydrogen and a flow rate B of silane are constant in accordance with the elapse of deposition time T. A flow rate of the source gas including the non-silicon based ele ment such as oxygen or carbon varies alternately within a range bet ween a first flow rate value a and a second flow rate value β in acc ordance with the elapse of deposition time T. The first flow rate valu e a and the second flow rate value β are reduced in accordance wit h the elapse of deposition time T.

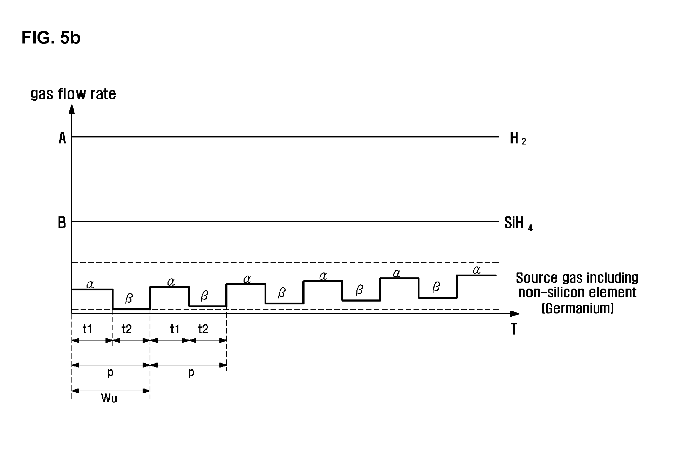

As shown in Fig. 5B, the flow rate A of hydrogen and the flow rate B of silane are constant in accordance with the elapse of deposition time T. The flow rate of the source gas including the non-silicon ba sed element such as germanium varies alternately within a range be tween the first flow rate value a and the second flow rate value β in accordance with the elapse of deposition time T. The first flow rate value α and the second flow rate value β are increased in accordanc e with the elapse of deposition time T. In this case, as shown in Fig s. 5A and 5B, during one cycle P derived from a sum of a duration time of the first flow rate value α and a duration time of' the second flow rate value β, the duration time t1 of the first flow rate value α and the duration time t2 of the second flow rate value β are const ant in accordance with the elapse of deposition time T.

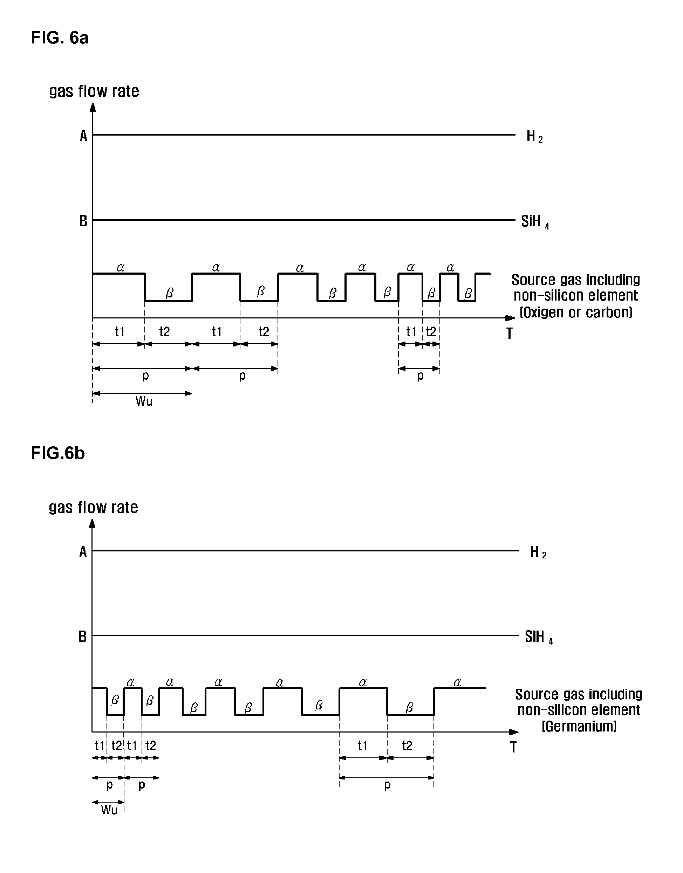

Figs. 6A to 6B show another variation of flow rate of source gas for forming a light absorbing layer according to an embodiment of the present invention.

As shown in Fig. 6A, the flow rate A of hydrogen and the flow rate B of silane are constant in accordance with the elapse of deposition time T. The flow rate of the source gas including the non-silicon ba sed element such as oxygen or carbon varies alternately within a ra nge between the first flow rate value α and the second flow rate val ue β in accordance with the elapse of deposition time T. During one cycle P derived from a sum of a duration time of the first flow rate value α and a duration time of the second flow rate value β, the d uration time t1 of the first flow rate value α and the duration time t 2 of the second flow rate value β are reduced in accordance with th e elapse of deposition time T.

As shown in Fig. 6B, the flow rate A of hydrogen and the flow rate B of silane are constant in accordance with the elapse of deposition time T. The flow rate of the source gas including the non-silicon based element such as germanium varies alternately within a range between the first flow rate value α and the second flow rate value β in accordance with the elapse of deposition time T. During one cycle P derived from a sum of a duration time of the first flow rate value α and a duration time of the second flow rate value β, the duration time t1 of the first flow rate value α and the duration time t2 of the second flow rate value β are increased in accordance with the elapse of deposition time T.

Here, as shown in Figs. 6A and 6B, the first flow rate value α and the second flow rate value β are constant in accordance with the elapse of deposition time T. During one cycle P derived from a sum of a duration time of the first flow rate value α and a duration time of the second flow rate value β, a ratio of the duration time t1 of the first flow rate value α to the duration time t2 of the second flow rate value β is constant in accordance with the elapse of deposition time T.

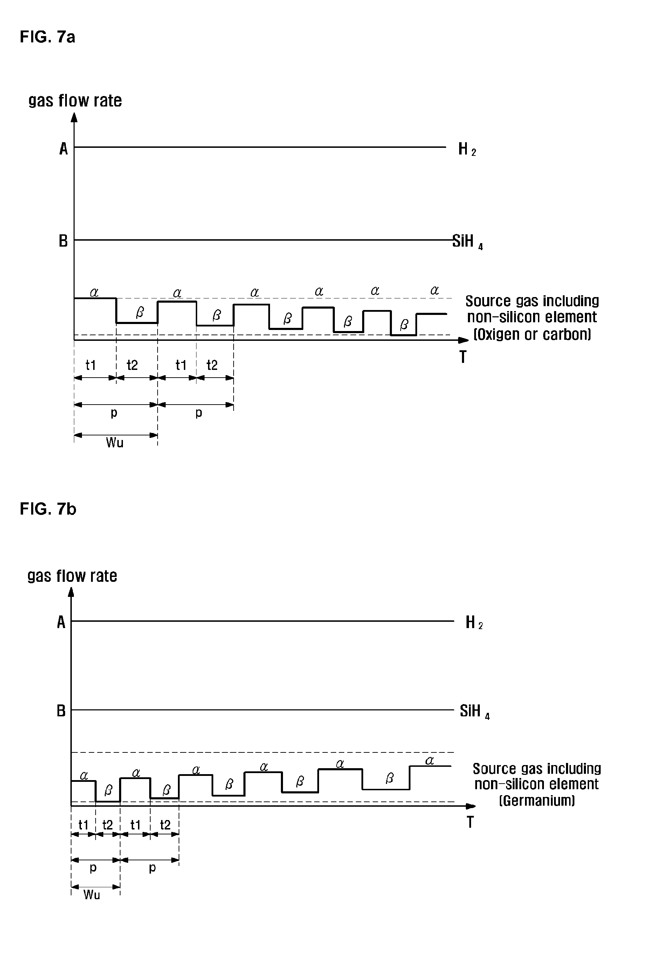

Figs. 7A to 7B show further another variation of flow rate of source gas for forming a light absorbing layer according to an embodiment of the present invention.

As shown in Fig. 7A, the flow rate A of hydrogen and the flow rate B of silane are constant in accordance with the elapse of deposition time T. The flow rate of the source gas including the non-silicon based element such as oxygen or carbon varies alternately within a range between the first flow rate value α and the second flow rate value β in accordance with the elapse of deposition time T. In this case, during one cycle P derived from a sum of a duration time of' the first flow rate value α and a duration time of the second flow rate value β, the duration time t1of the first flow rate value α and the duration time t2 of the second flow rate value β are reduced in accordance with the elapse of deposition time T. The first flow rate value α and the second flow rate value β are reduced in accordance with the elapse of deposition time T.

As shown in Fig. 7B, the flow rate A of hydrogen and the flow rate B of silane are constant in accordance with the elapse of deposition time T. The flow rate of the source gas including the non-silicon based element such as germanium varies alternately within a range between the first flow rate value α and the second flow rate value β in accordance with the elapse of deposition time T, In this case, during one cycle P derived from a sum of a duration time of the first flow rate value α and a duration time of the second flow rate value β, the duration time t1 of the first flow rate value α and the duration time t2 of the second flow rate value β are increased in accordance with the elapse of deposition time T. The first flow rate value α and the second flow rate valuer are increased in accordance with the elapse of deposition time T.

In this case, During one cycle P derived from a sum of a duration time of the first flow rate value α and a duration time of the second flow rate value β, a ratio of the duration time t1 of the first flow rate value α to the duration time t2 of the second flow rate value β is constant in accordance with the elapse of deposition time T.

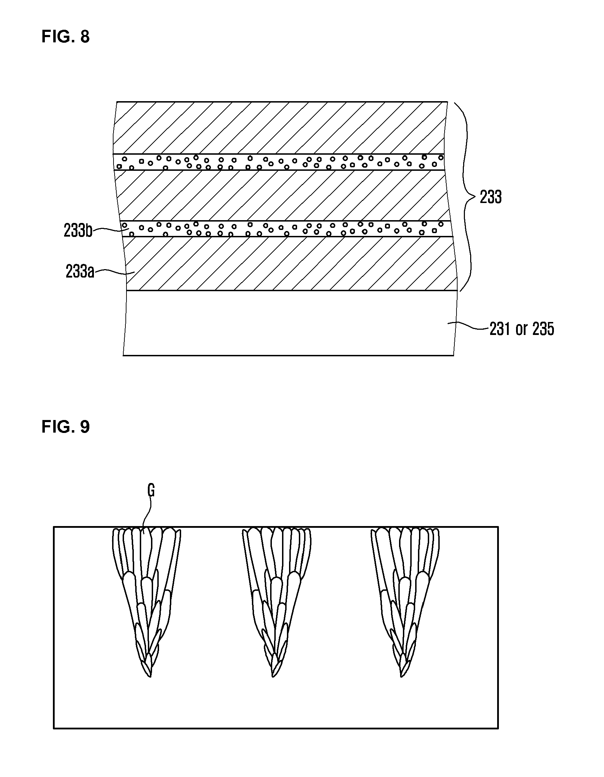

As described with reference to Figs. 5A to 7B, in the embodiments of' the present invention, the flow rate A of hydrogen and the flow rate B of silane are constant in accordance with the elapse of deposition time T, Additionally, with respect to the source gas including non-silicon based element, a ratio of a duration time t1 of the first flow rate value α to a duration time t2 of the second flow rate value β is constant as well. As a result, the first sub-layer 233A and the second sub-layer 233B of Fig. 8 are formed, which have a certain thickness ratio therebetween.

In this case, the flow rate of the source gas including non-silicon based element decreases or increases, varying alternately within a range between the first flow rate value α and the second flow rate value β in accordance with the elapse of deposition time T. This will be described later in detail.

As such, the flow rate A of hydrogen and the flow rate B of silane are constant in accordance with the elapse of deposition time T. The flow rate of the source gas including non-silicon based element varies alternately within a range between the first flow rate α and the second flow rate β. Therefore, a hydrogen dilution ratio, that is, a ratio of the flow rate of the silane to the flow rate of the hydrogen, is constant.

In addition, if the flow rate of the source gas including non-silicon based element varies, as shown in Fig. 8, a light absorbing layer including a plurality of sub-layers 233A and 233B is made on the p-type semiconductor layer 231 or the n-type semiconductor layer 235. The sub-layer 233A is a hydrogenated amorphous silicon based sub-layer (a-Si:H) including an amorphous silicon based element. The sub-layer 233B is a hydrogenated proto-crystalline silicon based sub-layer (pc-Si:H) including a crystalline silicon grain. The hydrogenated proto-crystalline silicon based sub-layer 233B is produced during the process of a phase change of the amorphous silicon progress to micro-crystalline silicon. Hereinafter, the hydrogenated amorphous silicon based sub-layer is referred to as the first sub-layer 233A. The hydrogenated proto-crytalline silicon based sub-layer is referred to as the second sub-layer 233B.

The higher the flow rate of the source gas including non-silicon based element increases, the lower the crystalline and a deposition rate are, The lower the flow rate of the source gas including non-silicon based element decreases, the higher the crystalline and a deposition rate are. Therefore, as shown in Figs. 5A to 7B, the first sub-layer 233A is formed during the duration time t1 of the flow rate value α of the source gas including non-silicon based element. The second sub-layer 233B is formed during the duration time t2 of the flow rate value β of the source gas including non-silicon based element.

Therefore, when the source gas including the non-silicon based element such as oxygen is supplied to the chamber, the first sub-layer 233A and the second sub-layer 233B include hydrogenated amorphous silicon oxide (i-a-SiO:H). The second sub-layer 233B includes a crystalline silicon grain surrounded by the hydrogenated amorphous silicon oxide (i-a-SiO:H),

When the source gas including the non-silicon based element such as carbon is supplied to the chamber, the first sub-layer 233A and the second sub-layer 233B include hydrogenated amorphous silicon carbide (i-a-SiC:H). The second sub-layer 233B includes a crystalline silicon grain surrounded by the hydrogenated amorphous silicon carbide (i-a-SiC:H).

When the source gas including the non-silicon based element such as germanium is supplied to the chamber, the first sub-layer 233A and the second sub-layer 233B include hydrogenated amorphous silicon germanium (i-a-SiGe:H). The second sub-layer 233B includes a crystalline silicon grain surrounded by the hydrogenated amorphous silicon germanium (i-a-SiGe:H).

Here, as shown in Figs. 5A to 7B, unless the source gas including non-silicon based element is supplied to the chamber during the time t2, that is, the second flow rate value β is equal to 0, the second sub-layer 233B includes a crystalline silicon grain surrounded by the hydrogenated amorphous silicon (i-a-Si:H).

In this case, the diameter of the crystalline silicon grain can be equal to or more than 3nm and equal to or less than 10nm, If the crystalline silicon grain has a diameter less than 3nm, it is difficult to form the crystalline silicon grain and a degradation rate reduction effect of a solar cell is reduced. If the crystalline silicon grain has a diameter greater than 10mm, the volume of grain boundary in the circumference of the crystalline silicon grain is excessively increased. As a result, the crystalline silicon grain is also increasingly recombined with each other, thereby reducing the efficiency.

As such, when the light absorbing layer 233 including a plurality of the sub-layers 233A and 233B is made, the degradation rate, i.e., a difference between an initial efficiency and a stabilization efficiency, is reduced. Accordingly, the photovoltaic device according to the embodiment of the present invention can have a high stabilization efficiency.

In other words, the first sub-layer 233A made of an amorphous silicon based material prevents columnar growth of the crystalline silicon grain of the second sub-layer 233B. As shown in Fig. 9, when the light absorbing layer is formed of only a proto-crystalline silicon layer unlike the embodiment of the present invention, the columnar growth of the crystalline silicon grain is accomplished. That is to say, as deposition is performed, the diameter of the crystalline silicon grain G is increased. Such a columnar growth of the crystalline silicon grain increases not only a recombination rate of a carrier such as an electron hole or an electron, but also a time required for the efficiency of the photovoltaic device to reach the stabilization efficiency by crystalline silicon grains having non-uniform diameter, The stabilization efficiency of the photovoltaic device is also reduced.

However, in the case of the light absorbing layer 233 including a plurality of sub-layers 233A and 233B in the embodiment of the present invention, since a short-range-order (SRO) and a medium-range-order (MRO) are improved, the degradation of the light absorbing layer 233 is rapid and the stabilization efficiency is increased. The amorphous silicon based material of the first sub-layer 233A prevents the columnar growth of the crystalline silicon grain, thereby reducing a diameter variation of the crystalline silicon grain. As a result, a time required for the efficiency of the photovoltaic device to reach the stabilization efficiency is reduced and a high stabilization efficiency is obtained.

The crystalline silicon grains of the second sub-layer 233B are covered with amorphous silicon based material and separated from each other. The separated crystalline silicon grain performs a core function of radioactive recombination of a part of captured carriers, preventing photocreation of dangling bond. This reduces non-radioactive recombination of the amorphous silicon based material, which surrounds the crystalline silicon grains, of the second sub-layer 233B.

Meanwhile, as shown in Figs. 5A, 6A and 7A, in accordance with the elapse of deposition time T, reduced are the first flow rate value α and the second flow rate valuer β of the source gas including non-silicon based element such as oxygen or carbon, or reduced are a duration time t1 of the first flow rate value α and a duration time t2 of the second flow rate value β. In Figs. 5A, 6A and 7A, while all of the first flow rate value α and the second flow rate value β are reduced, at least one of the values α and β can be reduced. Also, all of the duration time t1 of the first flow rate value α and the duration time t2 of the second flow rate value β can be reduced. At least one of the duration times of t1 and t2 can be also reduced. The first sub-layers 233A and the second sub-layers 233B, which are formed in accordance with the first flow rate value α and the second flow rate value β, of the light absorbing layer 233 are formed far from a side of incident light. Therefore, the farther the first and the second sub-layeaws 233a and 233B are from a side of incident light, the smaller the optical band gap of the first and the second sub-layers 233a and 233B gradually are.

Light with a short wavelength having a high energy density has a small penetration depth. A larger optical band gap is required to absorb light with a particular wavelength having a high energy density. Therefore, the closer the sub-layers 233A and 233B are to a side of incident light, the relatively larger optical band gap the sub-layers 223A and 233B have. As a result, light with a particular wavelength having a high energy density is absorbed as much as possible. The farther the sub-layers 233A and 233B are from a side of incident light, the relatively less optical band gap the sub-layers 233A and 233B have. As a result, light with a wavelength other than the particular wavelength mentioned above is absorbed as much as possible.

Here, the more the flow rate of the source gas including non-silicon based element such as oxygen or carbon is increased, the larger the optical band gap is. Therefore, in accordance with the elapse of deposition time T, reduced are the first flow rate value α and the second flow rate value β of the source gas including non-silicon based element such as oxygen or carbon, or reduced are a duration time t1 of the first flow rate value α and a duration time t2 of the second flow rate value β.

In addition, as shown in Figs. 5B, 6B and 7B, in accordance with the elapse of deposition time T, increased are the first flow rate value α and the second flow rate value β of the source gas including non-silicon based element such as germanium, or increased are a duration time t1 of the first flow rate value α and a duration time t2 of the second flow rate value β. In Figs. 5B, 6B and 7B, while all of the first flow rate value α and the second flow rate value β are increased, at least one of the values α and β can be increased. Also, all of the duration time t1 of the first flow rate value α and the duration time t2 of the second flow rate value β can be increased. At least one of' the duration times of t1 and t2 can be also increased. The first sub-layers 233A and the second sub-layers 233B, which are formed in accordance with the first flow rate value α and the second flow rate value β, of the light absorbing layer 233 are formed far from a side of incident light. Therefore, the farther the first and the second sub-layers 233a and 233B are from a side of incident light, the smaller the optical band gap of the first and the second sub-layers 233a and 233B gradually are.

In this case, the more the flow rate of the source gas including non-silicon based element such as germanium is increased, the smaller the optical band gap is. Therefore, in accordance with the elapse of deposition time T, increased are the first flow rate value a and the second flow rate value β of the source gas including non-silicon based element such as germanium, or reduced are a duration time t1 of the first flow rate value α and a duration time t2 of the second flow rate valve β.

As described above, light with a particular wavelength having a high energy density has a small penetration depth. A larger optical band gap is required to absorb light with a particular wavelength having a high energy density.

Therefore, the lower flow rate the source gas including non-silicon based element such as germanium has, the relatively larger optical band gap the sub-layers 233A and 233B closer to a side of incident light have. As a result, the sub-layers 233A and 233B closer to a side of incident light absorb light with a particular wavelength as much as possible.

Also, the larger flow rate the source gas including non-silicon based element such as germanium has, the relatively less optical band gap the sub-layers 233A and 233B farther from a side of incident light have. As a result, the sub-layers 233A and 233B farther from a side of incident light absorb light with a wavelength other than the particular wavelength mentioned above as much as possible.

In the mean time, as described above, the hydrogen dilution ratio and the pressure in the chamber 310 in the embodiment of the present invention are constant. Since a flow rates of hydrogen and silane supplied to the inside of the chamber 310 are larger than the flow rate of the source gas including non-silicon based element, it is relatively more difficult to control the flow rates of hydrogen and silane than to control the flow rate of the source gas including non-silicon based element, and a vortex can be generated in the chamber 310 due to the flows of hydrogen and silane Accordingly, if the flow rates of the hydrogen and the silane are constant, it is easy to control the source gas including non-silicon based element having low flow rates and possible to reduce the possibility of generating a vortex within the chamber 310, thereby improving a film characteristic of the light absorbing layer 233.

If the flow rate of hydrogen varies within a range between O and a certain value so as to form the first sub-layer 233A and the second sub-layer 233B, during a period of time during which the flow rate of hydrogen is equal to 0 as the flow rate of hydrogen varies cyclically, that is, a period of time during which hydrogen is not flown from the outside to the chamber, the hydrogen which remains in the chamber 310 increases in accordance with deposition time T, increasing crystallines of the sub-layers. As a result, it is difficult to form sub-layers having a uniform crystalline diameter and a uniform thickness.

On the other hand, in the embodiment of the present invention, since the flow rates of hydrogen and silane are constant and the flow rate of the source gas including non-silicon based element varies cyclically, an amount of hydrogen in the chamber 310 is maintained constant, making it easier to form the sub-layers 233A and 233B having a uniform crystalline diameter and a uniform thickness.

As described above, in the embodiments of the present invention, plasma-enhanced chemical vapor deposition method is used instead of photo-CVD. The photo-CVD is not suitable for manufacturing a large area photovoltaic device. Also, as deposition is performed, a thin film is deposited on a quartz window of a photo-CVD device, reducing UV light transmitting the quartz window.

For this reason, a deposition rate is gradually reduced and the thicknesses of the first sub-layer 233A and the second sub-layer 233B are gradually reduced. Contrarily, the plasma-enhanced chemical vapor deposition method can solve the defects of the photo-CVD.

In the plasma-enhanced chemical vapor deposition method used in the embodiment of the present invention, a frequency of a voltage supplied from an electric power source E can be equal to or more than 13.56 MHz. When a frequency of a voltage supplied from an electric power source E is equal to or more than 27.12 MHz, a deposition rate is improved and a quantum dot caused by a crystalline silicon grain can be easily formed.

As mentioned above, the crystalline silicon grain having a uniform diameter reduces a time required for the efficiency of the photovoltaic device to reach the stabilization efficiency and improves the stabilization efficiency. To this end, in the embodiment of the present invention, the hydrogen dilution ratio of the chamber 310 is maintained constant while the second sub-layer 233B of the light absorbing layer 233 is repeatedly deposited.

When oxygen or carbon as a source gas including non-silicon based element is flown to the chamber 310, the thickness of the light absorbing layer 233 is equal to or more than 150nm and is equal to or less than 300nm. An average oxygen content of the light absorbing layer 233 can be equal to or more than 0 atomic % and is equal to or less than 3 atomic %. An optical band gap of the light absorbing layer 233 can be equal to or more than 1,85eV and is equal to or less than 2.1 ev,

If the optical band gap of the light absorbing layer 233 formed by a flow of oxygen or carbon is equal to or more than 1.85eV, the light absorbing layer 233 can absorb a lot of light with a short wavelength having a high energy density. If the optical band gap of the light absorbing layer 233 is greater than 2, 1eV, the light absorbing layer 233 including the plurality of sub-layers 233A and 233B is difficult to form and absorption of light is reduced. Therefore, the efficiency can be reduced by reduction of a short-circuit current.

When an average oxygen content or an average carbon content of the light absorbing layer 233 formed by a flow of oxygen or carbon is greater than 3 atomic %, the optical band gap of the light absorbing layer 233 is rapidly increased and a dangling bond density is suddenly increased. As a result, the short-circuit current and a fill factor (FF) are reduced, so that the efficiency is degraded.

Thus, the light absorbing layer 233 formed by a flow of oxygen or carbon can be included in a top cell of a multiple junction photovoltaic device so as to absorb a lot of light with a short wavelength. The top cell corresponds to a photoelectric transformation layer on which light is first incident, among a plurality of photoelectric transformation layers 230.

When germanium as a source gas including non-silicon based element is flown to the chamber 310, the thickness of the light absorbing layer 233 is equal to or more than 300nm and is equal to or less than 1000nm. An average germanium content of the light absorbing layer 233 can be equal to or more than 0 atomic % and is equal to or less than 20 atomic %. An optical band gap of the light absorbing layer 233 can be equal to or more than 1.3eV and is equal to or less than 1,7 eV. If the optical band gap of the light absorbing layer 233 formed by a flow of germanium is equal to or more than 1.3eV and is equal to or less than 1.7 eV, the deposition rate of the light absorbing layer 233 is prevented from being rapidly reduced and the dangling bond density and a recombination are reduced. Therefore, the efficiency is prevented from being degraded.

If an average germanium content of the light absorbing layer 233 formed by a flow of germanium is greater than 20 atomic %, the deposition rate of the light absorbing layer 233 is rapidly reduced and a recombination is increased by the increase of the dangling bond density. Consequently, the short-circuit current, the fill factor (FF) and the efficiency are reduced.

Meanwhile, when the light absorbing layer 233 is formed by a flow of oxygen, carbon or germanium, the average hydrogen content of the light absorbing layer 233 can be equal to or more than 15 atomic % and is equal to or less than 25 atomic %.

Thus, the light absorbing layer 233 formed by a flow of germanium can be included in either a bottom cell of a double junction photovoltaic device including two photoelectric transformation layers 230 or a middle cell of a triple junction photovoltaic device including three photoelectric transformation layers 230, The bottom cell is posterior to the top cell and corresponds to a photoelectric transformation layer on which light is incident among two photoelectric transformation layers 230. The middle cell is posterior to the top cell and corresponds to a photoelectric transformation layer on which light is incident among three photoelectric transformation layers 230.

That is to say, since the optical band gap of the light absorbing layer 233 formed by a flow of germanium is equal to or more than 1.3eV and is equal to or less than 1.7eV, and thus, is less than an optical band gap, which is equal to or more than 1.85eV and equal to or less than 2,1eV, of the light absorbing layer 233 used in the top cell. Accordingly, the light absorbing layer 233 formed by a flow of germanium can be used in either the bottom cell of the double junction photovoltaic device or the middle cell of the triple junction photovoltaic device including three photoelectric transformation layers 230.

While the first sub-layer 233A is formed first in the embodiments of the present invention, the second sub-layer 233B can be also formed first.

A warming-up period WU can be provided before starting to deposit the light absorbing layer 233, In other words, as shown in Figs. 5A to 7B, a voltage is not supplied to the electrode 340 of the chamber 310 during a period of time more than a first cycle P for supplying the non-silicon source gas, which includes non-silicon based element, with the first flow rate value α and the second flow rate value β. The period of time corresponds to the warming-up period.

Because a voltage is not supplied to the chamber during the warming-up period, plasma is not generated. Since the chamber 310 is in a vacuum state, a condition inside the chamber 310 may not satisfy the deposition condition of the light absorbing layer 233 even though source gas for forming the light absorbing layer 233 is supplied to the chamber.

Therefore, in the case where a deposition is not performed due to no generation of plasma during the warming-up period WU and where a deposition is performed by generation of plasma when a condition inside the chamber 310 satisfies the deposition condition of the light absorbing layer 233 after the warming-up period WU, the light absorbing layer 233 can be stably formed.

As shown in Figs. 5B, 6B and 7B, the source gas including non-silicon based element such as germanium is supplied to the chamber such that the second flow rate value β is 0. Silane and hydrogen are uniformly supplied to the chamber. Here, if a hydrogen dilution patio (that is, a ratio of the flow rate of silane to the flow rate of hydrogen) is large, crystallization of silicon is performed.

Accordingly, the second sub-layer 233B is made of hydrogenated micro-crystalline silicon (µc-Si:H) including a crystalline silicon grain. The first sub-layer 233A is made of hydrogenated micro-crystalline silicon germanium (µc-SiGe:H).

Since the first and the second sub-layers 233A and 233B have less optical band gaps than those of the sub-layers made of amorphous silicon germanium, the first and the second sub-layers 233A and 233B can easily absorb light with a long wavelength. Accordingly, the light absorbing layer of the bottom cell of the double or triple junction photovoltaic device can include both the second sub-layer 233B including hydrogenated micro-crystalline silicon including a crystalline silicon grain and the first sub-layer 233A including hydrogenated micro-crystalline silicon germanium.

In order to absorb light with a long wavelength, an optical band gap of the light absorbing layer 233 made of hydrogenated micro-crystalline silicon germanium and hydrogenated micro-crystalline silicon can be equal to or more than 0.9eV and equal to or less than 1.3eV. An average germanium content of the light absorbing layer 233 can be is greater than 0 atomic % and equal to or less than 15 atomic %.

A thickness of the light absorbing layer 233 made of hydrogenated znicro-crystalline silicon germanium and hydrogenated micro-crystalline silicon can be equal to or more than 0.5µm and equal to or less than 1.0µm. If the thickness of the light absorbing layer 233 is less than 0.5µm, the light absorbing layer 233 cannot perform its functions. If more than 1.0 µm, the thickness is so large that its efficiency is reduced.

A thickness of the second sub-layer 233B, which includes a crystalline silicon grain, made of hydrogenated micro-crystalline silicon can be equal to or more than 20nm. If the thickness of the second sub-layer 233B is less than 20nm, it is difficult to form a crystalline silicon grain. Thus, it is hard to obtain the effect of the light absorbing layer 233 including the first and the second sub-layers 233A and 233B.

As described above, the thickness of the light absorbing layer 233 can be equal to or more than 0,5µm and equal to or less than 1.0µm. Also, a period of time equal to or more than 5 cycles P and equal to or less than 10 cycles P may be required in order that the light absorbing layer 233 including the first and the second sub-layers 233A and 233B can fully perform its function. Therefore, when germanium with the first flow rate value α and the second flow rate value β (equal to 0) is supplied to the chamber during one cycle P, a sum of the thickness of the first sub-layer 233A and the thickness of the sub-layer 233B can be equal to or more than 50nm and equal to or less than 100nm.

An average crystal volume fraction of the light absorbing layer 233 made of hydrogenated micro-crystalline silicon germanium and hydrogenated micro-crystalline silicon can be equal to or more than 30% and equal to or less than 60%, If the average crystal volume fraction is less than 30%, amorphous silicon is generated a lot and carriers are increasingly recombined with each other, thereby reducing the efficiency. If the average crystal volume fraction is more than 60%, a volume of grain boundary in a crystalline material is increased and a crystal defect is increased, thereby increasing the recombination of carriers.

An average oxygen content of the light absorbing layer 233 made of hydrogenated micro-crystalline silicon germanium and hydrogenated micro-crystalline silicon can be equal to or less than 1.0 x 1020 atoms/cm3. If the average oxygen content of the light absorbing layer 233 is more than 1.0 x 1020 atoms/cm3, a conversion efficiency is reduced. While the first sub-layer 233A is formed first in the embodiment of' the present invention, the second sub-layer 233B can be formed prior to the first sub-layer 233A.

The foregoing embodiments and advantages are merely exemplary and are not to be construed as limiting the present invention. The present teaching can be readily applied to other types of apparatuses. The description of the foregoing embodiments is intended to be illustrative, and not to limit the scope of the claims. Many alternatives, modifications, and variations will be apparent to those skilled in the art. In the claims, means-plus-function clauses are intended to cover the structures described herein as performing the recited function and not only structural equivalents but also equivalent structures. Moreover, unless the term "means" is explicitly recited in a limitation of the claims, such limitation is not intended to be interpreted under 35 USC 112(6).

## Claims

1. A photovoltaic device comprising:
a substrate 100;
a first electrode 210 disposed on the substrate;
at least one photoelectric transformation layer 230 disposed on the first electrode, the photoelectric transformation layer comprising a light absorbing layer 233; and
a second electrode 250 disposed on the photoelectric transformation layer;
wherein the light absorbing layer comprises a first sub-layer 233A and a second sub-layer 233B, which comprise a hydrogenated amorphous silicon based material respectively; and
wherein the first sub-layer and the second sub-layer comprise a non-silicon based element; and
wherein the second sub-layer comprises a crystalline silicon grain surrounded by the hydrogenated amorphous silicon based material.

2. The photovoltaic device of claim 1, wherein the photoelectric transformation layer 230 comprises a first photoelectric transformation layer 230-1 and a second photoelectric transformation layer 230-2 disposed on the first photoelectric transformation layer 230-1, and wherein the light absorbing layer comprised in the second photoelectric transformation layer comprises the first sub-layer and the second sub-layer, each of which comprises hydrogenated micro-crystalline silicon germanium and hydrogenated micro-crystalline silicon respectively.

3. The photovoltaic device of claim 1, wherein the non-silicon based element comprises at least one of oxygen, carbon and germanium.

4. The photovoltaic device of claim 1 or 3, wherein if source gas comprising the non-silicon based element comprises oxygen or carbon, an average oxygen content or an average carbon content of the light absorbing layer is greater than 0 atomic % and equal to or less than 3 atomic %.

5. The photovoltaic device of claim 1 or 3, wherein if source gas comprising the non-silicon based element comprises germanium, an average germanium content or an average carbon content of the light absorbing layer is greater than 0 atomic % and equal to or less than 20 atomic %,

6. The photovoltaic device of claim 1, wherein a diameter of the crystalline silicon grain is equal to or more than 3 nm and equal to or less than 10 nm.

7. The photovoltaic device of claim 1 or 2, wherein an average hydrogen content of the light absorbing layer is equal to or more than 15 atomic % and equal to or less than 25 atomic %.

8. The photovoltaic device of claim 2, wherein the second photoelectric transformation layer is farther away than the first photoelectric transformation layer from the viewpoint of a side of incident light.

9. The photovoltaic device of claim 2, wherein an average germanium content of the light absorbing layer comprised in the second photoelectric transformation layer is greater than 0 atomic % and equal to or less than 15 atomic %.

10. The photovoltaic device of claim 2, wherein an average crystal volume fraction of the light absorbing layer comprised in the second photoelectric transformation layer is equal to or more than 30% and equal to or less than 60%.

11. The photovoltaic device of claim 1 or 2, wherein an average oxygen content of the light absorbing layer is equal to or less than 1.0 x 1020 atoms/cm3.

12. A method of manufacturing a photovoltaic device, the method comprising:
forming a first electrode 210 on a substrate 100;
forming at least one photoelectric transformation layer 230 on the first electrode 210 in a chamber 310, the photoelectric transformation layer comprising a light absorbing layer 233;
forming a second electrode 250 on the photoelectric transformation layer 230;
wherein flow rates of hydrogen and silane which are supplied to the chamber 310 are constant while the light absorbing layer 233 is formed; and
wherein, while the light absorbing layer is formed, a flow rate of source gas, which is supplied to the chamber and comprises a non-silicon based element, varies alternately within a range between a first flow rate value and a second flow rate value in accordance with a deposition time ; and
wherein at least one of the first flow rate value and the second flow rate value varies in accordance with the elapse of the deposition time while the light absorbing layer is formed.

13. A method of manufacturing a photovoltaic device, the method comprising:
forming a first electrode 210 on a substrate 100;
forming at least one photoelectric transformation layer 230 on the first electrode 210 in a chamber, the photoelectric transformation layer comprising a light absorbing layer 233;
forming a second electrode 250 on the photoelectric transformation layer230;
wherein flow rates of hydrogen and silane which are supplied to the chamber 310 are constant while the light absorbing layer 233 is formed; and
wherein, while the light absorbing layer is formed, a flow rate of source gas, which is supplied to the chamber and comprises a non-silicon based element, varies alternately within a range between a first flow rate value and a second flow rate value in accordance with a deposition time ; and
wherein, during one cycle derived from a sum of a duration time of the first flow rate value and a duration time of the second flow rate value, at least one of the duration times of the first flow rate value and the second flow rate value varies in accordance with the elapse of the deposition time.

14. The method of claim 12 or 13, wherein the source gas comprising the non-silicon based element comprises oxygen, carbon or germanium.

15. The method of claim 12, wherein if the source gas comprising the non-silicon based element comprises oxygen or carbon, at least one of the first flow rate value and the second flow rate value decreases in accordance with the elapse of the deposition time, and wherein a first sub-layer and a second sub-layer of the light absorbing layer, each of which is formed according to the first flow rate value and the second flow rate value respectively, are formed far from a side of incident light.

16. The method of claim 12, wherein, if the source gas comprising the non-silicon based element comprises germanium, at least one of the first flow rate value and the second flow rate value increases in accordance with the elapse of the deposition time, and wherein a first sub-layer and a second sub-layer of the light absorbing layer, each of which is formed according to the first flour rate value and the second flow rate value respectively, are formed far from a side of incident light.

17. The method of claim 13, wherein, if the source gas comprising the non-silicon based element comprises oxygen or carbon, during the one cycle at least one of the duration times of the first flow rate value and the second flow rate value decreases in accordance with the elapse of the deposition time, and wherein a first sub-layer and a second sub-layer of the light absorbing layer, each of which is formed according to the first flow rate value and the second flow rate value respectively, are formed far from a side of incident light.

18. The method of' claim 13, wherein, if the source gas comprising the non-silicon based element comprises germanium, during the one cycle at least one of the duration times of the first flow rate value and the second flow rate value increases in accordance with the elapse of the deposition time, and wherein a first sub-layer and a second sub-layer of the light absorbing layer, each of which is formed according to the first flow rate value and the second flow rate value respectively, are formed far from a side of incident light.

19. The method of claim 12, wherein, during one cycle derived from a sum of a duration time of the first flow rate value and a duration time of the second flow rate value, a duration time of the first flow rate value and a duration time of the second flow rate value are constant in accordance with the elapse of the deposition time.

20. The method of claim 13, wherein the first flow rate value and the second flow rate value are constant in accordance with the elapse of the deposition time.

21. The method of claim 12 or 13, wherein a ratio of a duration time of the first flow rate value to a duration time of the second flow rate value is constant.

22. The method of claim 12 or 13, wherein the first flow rate value is greater than the second flow rate value, and wherein the light absorbing layer's sub-layer comprising hydrogenated amorphous silicon substance is formed while the source gas with the first flow rate value is supplied to the chamber, and wherein the light absorbing layer's sub-layer comprising a crystalline silicon grain is formed while the source gas with the second flow rate value is supplied to the chamber.

23. The method of claim 12 or 13, wherein a voltage is not supplied to the electrode of the chamber during a period of time more than a first cycle for supplying the non-silicon source gas with the first flow rate value and the second flow rate value.

24. The method of claim 12 or 13, wherein a pressure of the chamber is constant.

25. The method of claim 12 or 13, wherein the light absorbing layer comprises a plurality of the first sub-layers and the second sub-layers, and wherein the closer the first sub-layers and the second sub-layers are to a side of incident light, the larger optical band gap the first sub-layers and the second sub-layers have.

26. The method of claim 12 or 13, wherein the first flow rate value is greater than the second flow rate value, and wherein the light absorbing layer's sub-layer comprising a crystalline silicon grain is formed while the source gas with the second flow rate value is supplied to the chamber, and wherein a diameter of the crystalline silicon grain is equal to or more than 3nm and equal to or less than 10nm.

27. The method of claim 12 or 13, wherein an average hydrogen content of the light absorbing layer is equal to or more than 15 atomic % and equal to or less than 25 atomic %.

28. The method of claim 12 or 13, wherein, if the source gas comprising the non-silicon based element comprises oxygen or carbon, an average oxygen content or an average carbon content of the light absorbing layer is greater than 0 atomic % and equal to or less than 3 atomic %.

29. The method of claim 12 or 13, wherein, if the source gas comprising the non-silicon based element comprises oxygen or carbon, an optical band gap of the light absorbing layer is equal to or more than 1.85eV and is equal to or less than 2.1eV.

30. The method of claim 12 or 13, wherein, if the source gas comprising the non-silicon based element comprises germanium, an average germanium content of the light absorbing layer is greater than 0 atomic % and equal to or less than 20 atomic %.

31. The method of claim 12 or 13, wherein, if the source gas comprising the non-silicon based element comprises germanium, an optical band gap of the light absorbing layer is equal to or more than 1.3eV and is equal to or less than 1.7eV.

32. The method of claim 12 or 13, wherein a frequency of a voltage supplied to the chamber is equal to or more than 27. 12MHz while the light absorbing layer is formed.

33. The method of claim 12 or 13, wherein the source gas comprising the non-silicon based element comprises germanium, and wherein the first flow rate value is greater than the second flow rate value and the second flow rate value has a value of O, and wherein the light absorbing layer comprises a first sub-layer formed while the source gas with the first flow rate value is supplied to the chamber, and a second sub-layer formed while the source gas with the second flow rate value is supplied to the chamber, and wherein the second sub-layer comprises hydrogenated micro-crystalline silicon comprising the crystalline silicon grain, and wherein the first sub-layer comprises hydrogenated micro-crystalline silicon germanium.

34. The method of claim 12 or 13, wherein the source gas comprising the non-silicon based element comprises germanium, and wherein the first flow rate value is greater than the second flow rate value and the second flow rate value has a value of 0, and wherein an optical band gap of the light absorbing layer is equal to or more than 0.9eV and is equal to or less than 1.3eV.

35. The method of claim 12 or 13, wherein the source gas comprising the non-silicon based element comprises germanium, and wherein the first flow rate value is greater than the second flow rate value and the second flow rate value has a value of 0, and wherein an average germanium content of the light absorbing layer is greater than O atomic % and equal to or less than 15 atomic %.

36. The method of claim 12 or 13, wherein the source gas comprising the non-silicon based element comprises germanium, and wherein the first flow rate value is greater than the second flow rate value and the second flow rate value has a value of 0, and wherein a thickness of the light absorbing layer is equal to or more than 0.5µm and equal to or less than 1.0µm.

37. The method of claim 12 or 13, wherein the source gas comprising the non-silicon based element comprises germanium, and wherein the first flow rate value is greater than the second flow rate value and the second flow rate value has a value of O, and wherein the light absorbing layer comprises a first sub-layer formed while the source gas with the first flow rate value is supplied to the chamber, and a second sub-layer formed while the source gas with the second flow rate value is supplied to the chamber, and wherein a thickness of the second sub-layer is equal to or more than 20 nm.

38. The method of claim 12 or 13, wherein the source gas comprising the non-silicon based element comprises germanium, and wherein the first flow rate value is greater than the second flow rate value and the second flow rate value has a value of 0, and wherein the light absorbing layer comprises a first sub-layer formed while the source gas with the first flow rate value is supplied to the chamber, and a second sub-layer formed while the source gas with the second flow rate value is supplied to the chamber, and wherein a sum of the thickness of the first sub-layer and the thickness of the second sub-layer, which are formed during one cycle derived from a sum of a duration time of the first flow rate value and a duration time of the second flow rate value, is equal to or more than 50nm and equal to or less than 100nm.

39. The method of claim 12 or 13, wherein the source gas comprising the non-silicon based element comprises germanium, and wherein the first flow rate value is greater than the second flow rate value and the second flow rate value has a value of 0, and wherein an average crystal volume fraction of the light absorbing layer is equal to or more than 30% and equal to or less than 60%.

40. The method of claim 12 or 13, wherein the source gas comprising the non-silicon based element comprises germanium, and wherein the first flow rate value is greater than the second flow rate value and the second flow rate value has a value of 0, and wherein an average oxygen content of the light absorbing layer is equal to or less than 1.0 x 1020 atoms/cm3.
